(19) Europäisches Patentamt
European Patent Office
Office européen des brevets

(11) **EP 1 796 269 A2**

(12) **EUROPÄISCHE PATENTANMELDUNG**

(43) Veröffentlichungstag:
**13.06.2007 Patentblatt 2007/24**

(51) Int Cl.:
**H03K 17/97** *(2006.01)*

(21) Anmeldenummer: 06025465.3

(22) Anmeldetag: **08.12.2006**

(84) Benannte Vertragsstaaten:
**AT BE BG CH CY CZ DE DK EE ES FI FR GB GR HU IE IS IT LI LT LU LV MC NL PL PT RO SE SI SK TR**
Benannte Erstreckungsstaaten:
**AL BA HR MK YU**

(30) Priorität: **09.12.2005 DE 202005019271 U**

(71) Anmelder: **TRW Automotive Safety Systems GmbH**
**63743 Aschaffenburg (DE)**

(72) Erfinder:
• **Stegmann, Volker**
  **63743 Aschaffenburg (DE)**
• **Röder, Michael**
  **36391 Sinntal (DE)**

(74) Vertreter: **Strass, Jürgen**
**Prinz & Partner GbR**
**Rundfunkplatz 2**
**80335 München (DE)**

(54) **Mehrstufiger kontaktloser Schalter**

(57) Ein mehrstufiger kontaktloser Schalter, insbesondere für ein Bedienelement in einem Kraftfahrzeug umfaßt einen beweglich angeordneten Magneten (10) und mehrere voneinander beabstandete Hallsensorelemente (14, 16, 18). Jedes Hallsensorelement (14, 16, 18) kann magnetfeldabhängig einen bestimmten Schaltzustand auslösen.

**Beschreibung**

Die Erfindung betrifft einen mehrstufigen kontaktlosen Schalter, insbesondere für ein Bedienelement in einem Kraftfahrzeug.

Mehrstufige Bedienelemente in Kraftfahrzeugen werden oft durch mehrere nebeneinander angeordnete Mikroschalter realisiert. Solche Bedienelemente haben neben dem vergleichsweise großen Platzbedarf und der aufwendigen mechanischen Konstruktion den Nachteil, daß sie verschleißbehaftet sind, da die elektrischen Kontakte durch physikalische Berührung von Kontaktelementen hergestellt werden.

Es sind kontaktlose Schalter allgemein bekannt, die auf dem Halleffekt basieren. Ein Beispiel für einen solchen Schalter mit zwei Schaltzuständen ist in der US 4 061 988 gezeigt. Ein auf einem Stift befestigter Permanentmagnet ist linear verschiebbar, wobei der Permanentmagnet aus einer Ausgangsposition in eine Position direkt neben einem Halleffekt-Sensorschaltkreis bewegt werden kann, der auf die Änderung des Magnetfelds reagiert und dadurch einen Schaltvorgang auslöst. Ein auf einem solchen Schaltertyp basierendes mehrstufiges Bedienelement würde aber wiederum mehrere Schalter erfordern.

Aufgabe der Erfindung ist es, eine möglichst platzsparende Schaltvorrichtung mit langer Lebensdauer zu schaffen, die auf komfortable Weise eine mehrstufige Bedienung ermöglicht.

Zur Lösung dieser Aufgabe wird ein mehrstufiger kontaktloser Schalter vorgeschlagen, mit einem beweglich angeordneten Magneten und mehreren voneinander beabstandeten Hallsensorelementen, wobei jedes Hallsensorelement magnetfeldabhängig einen bestimmten Schaltzustand auslösen kann. Die Erfindung beruht auf der Erkenntnis, daß das Konzept eines auf dem Halleffekt basierenden zweistufigen Schalters durch geeignete Konstruktion des Schalters auf mehrere Schaltzustände erweiterbar ist. Mit dem erfindungsgemäßen Schalter sind kontaktlose und damit verschleißfreie Schaltvorgänge in mehreren Stufen möglich, ohne daß hierfür ein vergrößertes Bedienfeld erforderlich wäre. Da keine physikalischen Berührungen von Kontaktelementen berücksichtigt werden müssen, kann die mechanische Realisierung der Schaltwege und Schaltpunkte weitgehend frei gestaltet werden, so daß eine komfortable Bedienung mit ansprechender Haptik realisierbar ist. Der prellfreie Schalter eignet sich somit für anspruchsvolle Kraftfahrzeuganwendungen, wie z.B. für die Betätigung eines Direktschaltgetriebes über ein am Lenkrad des Fahrzeugs angeordnetes Bedienelement.

Vorteilhafte und zweckmäßige Ausgestaltungen des erfindungsgemäßen Schalters sind in den Unteransprüchen angegeben.

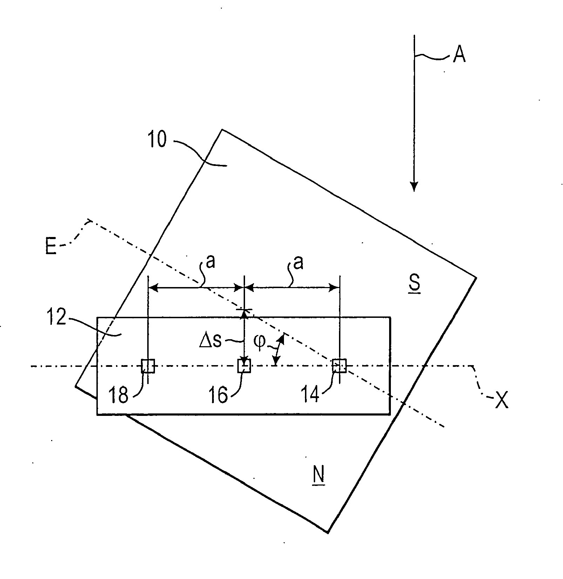

Weitere Merkmale und Vorteile der Erfindung ergeben sich aus der nachfolgenden Beschreibung und aus den beigefügten Zeichnungen, auf die Bezug genommen wird. In den Zeichnungen zeigt die einzige Figur schematisch die wesentlichen Elemente eines erfindungsgemäßen Schalters.

Die zweidimensionale Darstellung der Figur beschränkt sich auf die wesentlichen elektrischen und magnetischen Komponenten eines mehrstufigen kontaktlosen Schalters. Auf die mechanischen Komponenten des Schalters wird nach der Funktionsbeschreibung eingegangen.

Ein quaderförmiger Permanentmagnet 10 hat eine Äquatorebene E, die den Nordpol N vom Südpol S des Permanentmagneten 10 trennt. Der Permanentmagnet 10 kann linear in Richtung des Pfeils A und zurück bewegt werden.

Ein bipolar schaltendes Hall-IC-Bauteil 12 enthält mehrere (im dargestellten Beispiel drei) Hallsensorelemente 14, 16, 18, die eine Sensorachse X definieren. Die Hallsensorelemente 14, 16, 18 sind im gleichen Abstand a auf der Sensorachse X angeordnet. Das Hall-IC-Bauteil 12 ist so angeordnet, daß der Permanentmagnet 10 in unmittelbarer Nähe (in der Figur hinter dem Bauteil 12) vorbeigeführt wird, damit sichergestellt ist, daß die Hallsensorelemente 14, 16, 18 auf eine durch die Bewegung des Permanentmagneten 10 herbeigeführte Magnetfeldänderung zuverlässig und definiert ansprechen.

Die Bewegungsrichtung des Permanentmagneten 10 verläuft senkrecht zur Sensorachse X des Hall-IC-Bauteils. Die relative Orientierung des Hall-IC-Bauteils zum Permanentmagneten 10 ist so gewählt, daß die Sensorachse X gegenüber der Äquatorebene E des Permanentmagneten 10 um einen spitzen Winkel φ verkippt ist.

Im folgenden wird die Funktionsweise des mehrstufigen Schalters erläutert. Der Permanentmagnet 10 wird aus einer Ausgangsposition in Richtung des Pfeils A bewegt. Im Idealfall spricht das erste Hallsensorelement 14 genau dann an, wenn die Äquatorebene E des Permanentmagneten 10 an ihm vorbeistreicht, und löst daraufhin einen ersten Schaltvorgang aus (erster Schaltzustand). Diese Situation entspricht der Darstellung der Figur, die das erste Hallsensorelement 14 genau auf der Äquatorebene E zeigt.

Ausgehend von diesem Zustand ist eine weitere lineare Bewegung des Permanentmagneten 10 in Richtung des Pfeils A um die Strecke Δs (Schaltweg) erforderlich, bis das zweite Hallsensorelement 16 anspricht und einen zweiten Schaltvorgang auslöst (zweiter Schaltzustand). Diese Strecke Δs läßt sich mittels einfacher geometrischer Überlegungen aus dem Abstand a der beiden Hallsensorelemente 14 und 16 sowie dem Winkel φ zwischen der Sensorachse X und der Äquatorebene E berechnen:

$$\Delta s = a \cdot \tan \varphi$$

Entsprechendes gilt für den Schaltweg zum Erreichen des dritten Schaltzustands und für weitere Schaltwege im Falle weiterer Hallsensorelemente.

Das bedeutet umgekehrt, daß gemäß dem in der Figur gezeigten grundsätzlichen Aufbau des mehrstufigen Schalters der Schaltweg zwischen zwei Schaltzuständen durch den Abstand a zwischen den Hallsensorelementen 14, 16, 18 und dem Winkel φ zwischen der Sensorachse X und der Äquatorebene E vorgegeben werden kann. Selbstverständlich sind auch unterschiedliche Abstände der Hallsensorelemente 14, 16, 18 und damit unterschiedlich lange Schaltwege möglich.

Die mechanische Realisierung der Schaltwege und Schaltpunkte kann z.B. mittels einer geeigneten Kulisse erfolgen, in der zugeordnet zur Ausgangsposition des Permanentmagneten 10 und jedem Schaltpunkt eine Rastposition vorgesehen ist.

Anstelle eines quaderförmigen Permanentmagneten 10 kann auch eine andere Magnetform, z.B. ein zylinderförmiger Stabmagnet, oder ein anderer Magnettyp verwendet werden.

Die Anwendung des erfindungsgemäßen mehrstufigen kontaktlosen Schalters ist nicht auf die Bedienung eines Direktschaltgetriebes oder anderer Kfz-Bedienelemente beschränkt. Vielmehr kann der vorteilhafte Schalter allgemein im Haushaltsbereich und in der Industrie eingesetzt werden.

**Patentansprüche**

1. Mehrstufiger kontaktloser Schalter, insbesondere für ein Bedienelement in einem Kraftfahrzeug, mit einem beweglich angeordneten Magneten (10) und mehreren voneinander beabstandeten Hallsensorelementen (14, 16, 18), wobei jedes Hallsensorelement (14, 16, 18) magnetfeldabhängig einen bestimmten Schaltzustand auslösen kann.

2. Schalter nach Anspruch 1, **dadurch gekennzeichnet, daß** die Hallsensorelemente (14, 16, 18) in einem IC-Bauteil untergebracht sind.

3. Schalter nach Anspruch 1 oder 2, **dadurch gekennzeichnet, daß** die Hallsensorelemente eine Sensorachse X definieren, die gegenüber der Äquatorebene E des Magneten (10) verkippt ist.

4. Schalter nach Anspruch 3, **dadurch gekennzeichnet, daß** die Hallsensorelemente (14, 16, 18) in gleichen Abständen a auf der Sensorachse X angeordnet sind.

5. Schalter nach Anspruch 3, **dadurch gekennzeichnet, daß** die Hallsensorelemente (14, 16, 18) in ungleichen Abständen auf der Sensorachse X angeordnet sind.

6. Schalter nach einem der Ansprüche 3 bis 5, **dadurch gekennzeichnet, daß** der Magnet (10) eine vorgegebene Bewegungsrichtung hat, die senkrecht zur Sensorachse X verläuft.

7. Schalter nach einem der vorhergehenden Ansprüche, **dadurch gekennzeichnet, daß** eine Kulisse vorgesehen ist, die mehrere Rastpositionen des Magneten (10) definiert.

8. Schalter nach Anspruch 7, **dadurch gekennzeichnet, daß** die Anzahl der Rastpositionen gleich der oder größer als die Anzahl der Hallsensorelemente (14, 16, 18) ist.

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4061988 A